# FASCICULE DE BREVET EUROPEEN

(11) **EP 0 347 822 B1**
(45) Date de publication et mention de la délivrance du brevet: **01.09.1993**
(21) Numéro de dépôt: 89111157.7
(22) Date de dépôt: 20.06.1989
(51) Int. Cl.: H04L 27/22

(54) **Dispositif de filtrage avec arrondi sinusoidal en fréquence intermédiaire dans la partie réception d'un modem numérique**
Filtervorrichtung mit sinusförmiger Flankenabrundung für die Zwischenfrequenz im Empfängerteil eines digitalen Modems
Filtering device using sinusoidal roll-off at the intermediate frequency in the receiver of a digital modem

(30) Priorité: 24.06.1988 FR 8808508
(43) Date de publication de la demande: 27.12.1989
(73) Titulaire: ALCATEL TELSPACE, 92734 Nanterre Cédex (FR); ALCATEL N.V., NL-1077 XX Amsterdam (NL)
(72) Inventeur: Lemaitre, Didier, F-95000 Cergy (FR); Vitrant, Daniel, F-95630 Meriel (FR)
(74) Mandataire: Weinmiller, Jürgen

(56) Documents cités:
- EP-A- 0 106 163
- FR-A- 1 056 808
- US-A- 4 180 779
- IRE TRANSACTIONS ON CIRCUIT THEORY, vol. CT-8, no. 9, septembre 1961, pages 192-201, New York, US; C.A. DESOER et al.: "Design of lossy ladder filters by digital computer"
- COMSAT TECHNICAL REVIEW, vol. 17, no. 1, printemps 1987, pages 127-157, Clarksburg, MD, US; J.J. POKLEMBA: "Pole-zero approximations for the raised cosine filter family"

## Description

L'invention concerne un dispositif de filtrage avec arrondi sinusoïdal en fréquence intermédiaire dans la partie réception d'un modem numérique.

Plus particulièrement l'invention a trait à la réalisation d'un filtrage en racine de "roll-off" (ou "arrondi sinusoïdal") en fréquence intermédiaire, dans la partie réception d'un modem numérique QPSK ("Quadrature phase shift keying" ou modulation à 4 états de phase), tout en assurant le filtrage nécessaire pour la bande équivalente de bruit et la réjection des porteuses adjacentes.

L'ensemble d'une transmission numérique doit répondre au critère de "nyquist" pour ne pas provoquer de distorsion intersymboles. Pour cela un filtrage en "roll-off" est souvent employé. Généralement, celui-ci est décomposé en un filtre émission en racine de "roll-off" plus un filtrage en x/sin x pour le "blanchiment" du spectre, et en réception, par un second filtre en racine de "roll-off".

En effet, comme expliqué dans le manuel "traitement du signal" de R. BEAUVILLAIN (cours ENSEA), à partir d'un signal échantillonné pour lequel Fe ≧ 2fs max, on peut reconstituer le signal initial par filtrage idéal passe-bas de bande passante Bo = Fs max. Mais en pratique, il faut une certaine plage entre les spectres pour les séparer par filtrage. Idéalement, on montre qu'il est possible de reconstituer intégralement le signal initial en pondérant chaque échantillon par une fonction du temps de type sin u/u, et d'effectuer la somme des quantités obtenues. Pour diminuer les interférences entre échantillons on choisit un modèle de filtrage avec arrondi sinusoïdal ("sinusoïdal roll-off"), ce qui en pratique correspond à un élargissement de la bande passante nécessaire pour transmettre le signal.

Le démodulateur situé en réception nécessite à son entrée un filtrage sélectif étroit pour éliminer les porteuses adjacentes et limiter la bande équivalente de bruit. Il doit par ailleurs posséder une bande supérieure à celle de Nyquist pour ne pas perturber le filtrage en racine de "roll-off" effectué en bande de base sur chacun des trains. Ce filtrage sélectif impose l'utilisation d'éléments ayant des coefficients de surtension élevés, d'encombrement important et de réglages pointus.

La structure choisie sera généralement un filtre elliptique assurant une bonne sélectivité. La bande passante d'un filtre de ce type est supérieure à celle de Nyquist et apporte une dégradation du rapport porteuse/bruit à l'entrée de la récupération de porteuse.

Si l'on considère, en effet, des filtres de faible bande, ceux-ci introduisent obligatoirement de l'interférence entre symboles. Ceux de bande plus large, et ne respectant pas les conditions de Nyquist, en introduisent également mais de moins en moins à mesure que la bande augmente. A la limite un filtrage de bande infinie n'introduit pas d'interférence entre symboles. Le problème de l'interférence entre symboles peut donc être résolu en utilisant des filtres larges, mais les autres contraintes imposent au contraire l'utilisation de filtres les plus étroits possibles. Aussi la détermination de la largeur de bande du filtrage est-elle un compromis entre ces diverses contraintes.

Le filtrage en racine de "roll-off" en bande de base nécessite un filtre sur chaque train, pouvant apporter des distorsions différentes entre eux.

Lorsque le filtrage de Nyquist est réalisé en fréquence intermédiaire, il apporte une amélioration du rapport porteuse/bruit à l'entrée de la récupération de porteuse, et il assure une symétrie sur les deux trains démodulés. Par ailleurs le filtrage bande de base complémentaire se trouve très simplifié.

Toutefois ce filtrage en fréquence intermédiaire est assez délicat à réaliser. Les filtres plus couramment utilisés pour réaliser la fonction racine de "roll-off" sont les filtres de Butterworth ou de Tchebycheff, avec une bande optimale pour un taux d'erreur (compromis bande de bruit/distorsion intersymboles) situé entre 1,1 à 1,2 de la bande de Nyquist.

Les réjections hors bandes sont assez faibles mais nécessitent un nombre de pôles élevés, qui par ailleurs augmentent la distorsion intersymboles.

Comme exprimé dans le manuel intitulé "filtres actifs" de Paul Bildstein aux éditions Radio (3ème édition) notamment de la page 52 à la page 60, contrairement aux filtres polynomiaux (Butterworth, Tchebyscheff, ....) les filtres de CAUER sont des filtres tels qu'ils :
- possèdent le plus grand nombre de zéros de transmission possibles pour un ordre n donné ;
- ont une atténuation uniformément répartie aussi bien en bande passante qu'en bande coupée.

L'introduction de tels zéros a deux avantages :
- supprimer des fréquences particulièrement indésirables, comme par exemple la porteuse dans un filtre de démodulation en bande de base ;
- rendre la coupure du filtre beaucoup plus raide en plaçant un zéro de transmission immédiatement après la fréquence de coupure et cela sans augmenter l'ordre du filtre.

Comme mis en évidence dans le manuel de J.K. SKWIRZYNSKI intitulé "Design theory and data for electrical filters" de la page 157 à 160 illustré à la figure 8-1, l'utilisation de faibles coefficients de surtension entraîne un certain nombre d'effets néfastes sur la courbe de réponse d'un tel filtre.

De plus l'article de C.A. Desoer and S.K. Mitra: "Design of lossy ladder filters by digital computer", IRE Transactions on Circuit Theory, vol. CT-8, no.9, sept. 1961, pp. 192-201, divulgue une méthode pour rapprocher les caractéristiques d'un filtre utilisant des composants de faible coefficient de surtension de celles d'un filtre utilisant des composants idéaux.

Ainsi l'idée d'effectuer un filtrage à l'aide d'un filtre elliptique type CAUER est connue, surtout pour obtenir de bonnes réjections mais un filtre de ce type ne semble absolument pas adéquat pour réaliser une fonction de "roll-off", ce que propose l'invention qui a pour objet un dispositif de filtrage avec arrondi sinusoïdal en fréquence intermédiaire dans la partie réception d'un modem numérique, caractérisé en ce qu'il comprend un filtre elliptique de type CAUER équipé d'éléments inductifs dissipatifs de faible coefficient de surtension pour réaliser une fonction de "roll-off" ou "arrondi sinusoïdal".

Avantageusement une telle réalisation de la fonction de "roll-off" ("arrondi sinusoïdal" ou racine de "roll-off") en fréquence intermédiaire par un filtre elliptique de type CAUER, avec des éléments inductifs dissipatifs de faible coefficient de surtension (30 à 50), permet d'employer des inductances de faible coût et de faible encombrement : type surmoulées ou "CMS" (composants à montage de surface), avec ou sans résistances d'amortissement complémentaires.

Le dispositif de l'invention est d'autant plus avantageux que le nombre n d'états de la modulation, affectant le signal reçu, est important ; par exemple n ≧ 4.

Les caractéristiques et avantages de l'invention ressortiront d'ailleurs de la description qui va suivre, à titre d'exemple non limitatif, en référence aux figures annexées sur lesquelles :
- la figure 1 illustre schématiquement un exemple de réalisation du dispositif de l'invention ;
- la figure 2 représente des courbes illustrant le fonctionnement du dispositif selon l'invention.

L'invention consiste à utiliser comme dispositif de filtrage en fréquence intermédiaire dans la partie réception d'un modem numérique, par exemple QPSK, un filtre de CAUER, qui contrairement à l'habitude utilise des inductances possédant de faibles coefficients de surtension (30 à 50). Ceci d'une part supprime l'ondulation dans la bande, et d'autre part réalise "l'arrondi sinusoïdal" correspondant au racine de "roll-off" (par exemple r = 0,4) par amortissement de chaque pôle.

Des inductances classiques surmoulées ou de type "CMS" ("composants montés en surface") de faible encombrement et de coûts réduit par rapport à des inductances bobinées sur mandrins, sont alors utilisées.

Le réglage peut être optimisé par des résistances d'amortissement en parallèle sur les inductances. Le réglage est, alors, rendu plus facile et moins pointu.

L'ajustement en fréquence et l'amortissement des pôles adjacents à la bande de Nyquist, permettent d'obtenir la symétrie du filtre.

Plus le nombre n d'états de la modulation, affectant le signal reçu, est important plus le dispositif de l'invention est avantageux : on peut considérer par exemple n ≧ 4.

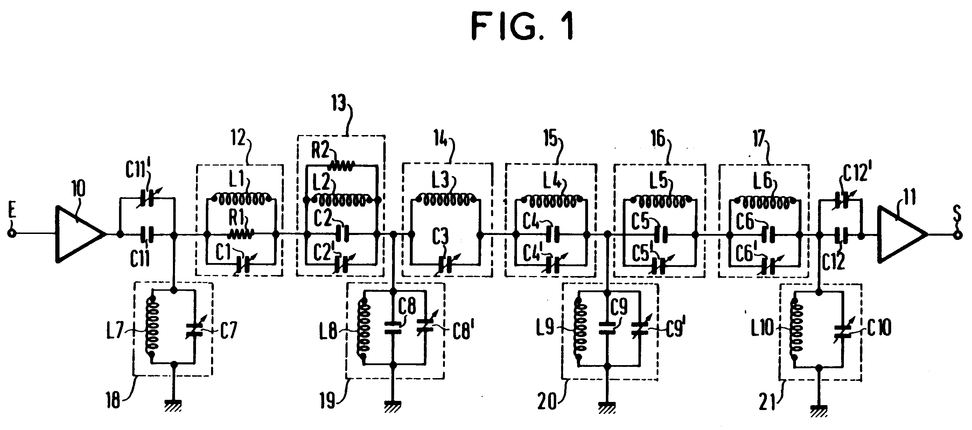

Le filtre représenté à la figure 1 a été réalisé dans un modulateur numérique QPSK à 49.152 Mbits : Il s'agit d'une structure de filtre CAUER en π à 7 pôles. Il est situé en fréquence intermédiaire à 45 MHz et de degré n=7. Son impédance interne est de 500 Ω, un transformateur capacitif le ramène sur 50 Ω. Il est encadré par des amplificateurs monolithiques 50 Ω (type AVANTEX OU MCL) 10 et 11 permettant un gain global nul. Les inductances utilisées sont des chips bobinés CMS (TDK). (Q=30 à 50 pour F=45 MHz).

Ce filtre comporte, par exemple :
- six cellules 12, 13, 14, 15, 16, 17 disposées en série entre les deux amplificateurs 10 et 11 ;
- quatre cellules 18, 19, 20, 21 disposées en parallèle entre les entrées respectives des premières (12), troisième (14), cinquième (16) cellules série et la masse, et entre la sortie de la sixième cellule (17) et la masse.

Ces différentes cellules sont formées d'éléments disposés en parallèles entre eux, ayant les valeurs suivantes :
. pour les cellules série :
   - R1 = 4,7 KΩ ; L1 = 820 nH ; C1 = 0-10 pF ;
   - R2 = 3,9 KΩ ; L2 = 3,9µ H ; C2 = 10 pF ; C2′ = 0-10 pF ;
   - L3 = 470 nH ; C3 = 0-10 pF ;
   - L4 = 1,2 µ H ; C4 = 33 µ F ; C4′ = 0-10 pF ;
   - L5 = 220 nH ; C5 = 33 pF ; C5′ = 0-10 pF ;
   - L6 = 680 nH ; C6 = 68 pF ; C6′ = 0-10 pF ;
. pour les cellules parallèles :
   - L8 = 330 nH ; C8 = 33 pF ; C8′ = 0-10 pF ;
   - L9 = 390 nH ; C9 = 47 pF ; C9′ = 0-10 pF ;
   - L10 = 330 nH ; C10 = 0-10 pF.

Deux capacités en parallèle sont disposées respectivement avant la première cellule série et après la dernière cellule série, soit :
- C11 = 33 pF ; C11′ = 0-10 pF ;
- C12 = 56 pF ; C12′ = 0-10 pF.

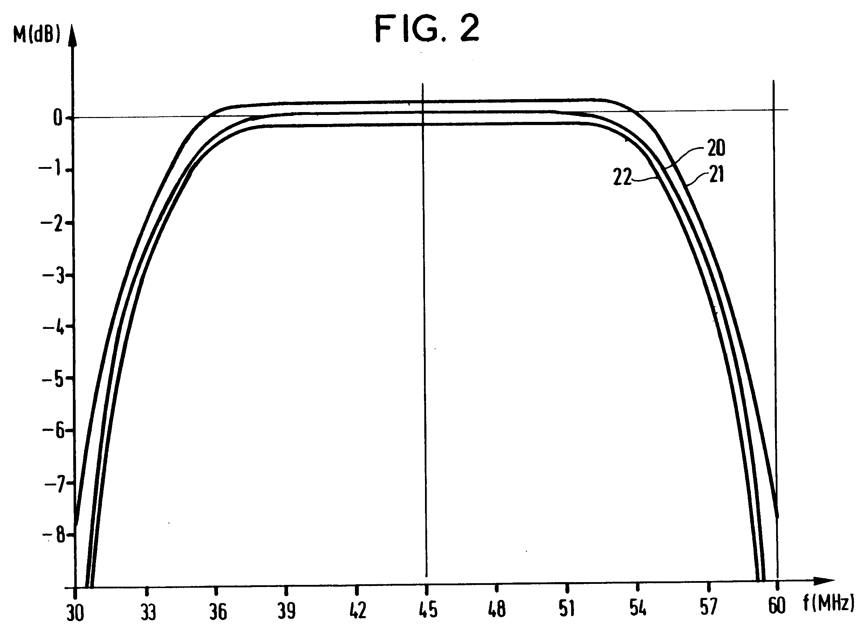

Les performances d'un tel filtre sont proches du racine de "roll-off" : r=0.4 à moins de 5% du théorique. Par ailleurs les réjections hors bande sont supérieures à 50 dB en fréquences hautes et supérieures à 65 dB en fréquences basses pour F ≧ 2*F Nyquist. Ainsi la courbe 20, représentée à la figure 2, est la courbe de réponse du filtre de la figure 1, en fréquence module. Les courbes 21, 22 sont les gabarits à ± 5% du "roll-off" théorique : r=0,4.

L'encombrement de ce filtre est réduit à 8*3 cm² (hors correcteur de temps de propagation de groupe). Les composants peuvent être montés par insertion automatique et soudés à la vague.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Dispositif de filtrage avec arrondi sinusoïdal en fréquence intermédiaire dans la partie réception d'un modem numérique, caractérisé en ce qu'il comprend un filtre elliptique de type CAUER équipé d'éléments inductifs dissipatifs de faible coefficient de surtension pour réaliser une fonction de "roll-off" ou "arrondi sinusoïdal"..

2. Dispositif selon la revendication 1, caractérisé en ce que le nombre d'états de phase de la modulation du signal reçu est plus grand ou égal à 4.

3. Dispositif selon l'une quelconque des revendications 1 ou 2, caractérisé en ce que les éléments inductifs dissipatifs ont un coefficient de surtension compris entre 30 et 50.

4. Dispositif selon l'une quelconque des revendications précédentes, caractérisé en ce qu'il comprend un filtre CAUER en π à 7 poles comprenant un amplificateur (10) en entrée et un amplificateur (11) en sortie et
- six cellules (12, 13, 14, 15, 16, 17) disposées en série entre les deux amplificateurs (10 et 11) ;
- quatre cellules (18, 19, 20, 21) disposées en parallèle entre les entrées respectives des premières (12), troisième (14), cinquième (16) cellules série et la masse, et entre la sortie de la sixième cellule (17) et la masse.

## Claims

1. A filtering device with a sinusoidal pulse edge rounding-off for the intermediate frequency in the receive part of a digital modem, characterized in that it comprises an elliptic filter of the CAUER type fitted with dissipative inductive elements having a low Q-factor in order to implement a "roll-off" or a "pulse edge rounding-off" function.

2. A device according to claim 1, characterized in that the number of phase states of the modulation of the received signal is higher than or equal to 4.

3. A device according to claim 1 or 2, characterized in that the dissipative inductive elements have a Q-factor lying between 30 and 50.

4. A device according to any one of the preceding claims, characterized in that it comprises a CAUER π-type filter with 7 poles, comprising an amplifier at the input and an amplifier at the output, and
- six cells (12, 13, 14, 15, 16, 17) disposed in series between two amplifiers (10 and 11);
- four cells (18, 19, 20, 21) disposed in parallel between the respective inputs of the first (12), third (14), fifth (16) cells and ground, and between the output of the sixth cell (17) and ground.

## Patentansprüche

1. Filtervorrichtung mit sinusförmiger Flankenabrundung im Zwischenfrequenzbereich eines Empfangsteils eines digitalen Modems, dadurch gekennzeichnet, daß sie ein elliptisches Filter vom Typ CAUER aufweist, das mit verlustbehafteten induktiven Elementen mit niedrigem Überspannungskoeffizienten versehen ist, um eine "Roll-off"-Funktion bzw. eine "sinusförmige Flankenabrundung" zu erzielen.

2. Vorrichtung nach Anspruch 1, dadurch gekennzeichnet, daß die Anzahl der Phasenzustände der Modulation des empfangenen Signals mindestens 4 beträgt.

3. Vorrichtung nach Anspruch 1 oder 2, dadurch gekennzeichnet, daß die verlustbehafteten induktiven Elemente einen Überspannungskoeffizienten zwischen 30 und 50 aufweisen.

4. Vorrichtung nach einem beliebigen vorhergehenden Anspruch, dadurch gekennzeichnet, daß sie ein π-Filter vom Typ CAUER mit 7 Polen enthält mit
- einem Verstärker (10) am Eingang und einen Verstärker (11) am Ausgang;
- sechs Zellen (12, 13, 14, 15, 16, 17), die in Reihe zwischen den beiden Verstärkern (10 und 11) angeordnet sind; und
- vier Zellen (18, 19, 20, 21), die parallel zwischen den jeweiligen Eingängen der in Reihe geschalteten ersten (12), dritten (14), fünften (16) Zellen und Masse, und zwischen den Ausgang der sechsten Zelle (17) und Masse angeordnet sind.
